# EUROPEAN PATENT APPLICATION

(11) **EP 4 756 807 A1**
(43) Date of publication of application: **10.06.2026**
(21) Application number: 25194487.2
(22) Date of filing: 07.08.2025
(51) Int. Cl.: G11C 7/24, G11C 16/14, G11C 16/22

(54) **STORAGE DEVICE AND OPERATING METHOD OF STORAGE DEVICE**

(30) Priority: 06.12.2024 KR 20240180943; 21.07.2025 US 202519275915
(71) Applicant: Samsung Electronics Co., Ltd., Suwon-si, Gyeonggi-do 16677 (KR)
(72) Inventor: KIM, Youhwan, 16677 Suwon-si, Gyeonggi-do (KR); SHIN, Seo-Hyun, 16677 Suwon-si, Gyeonggi-do (KR); LEE, Kyungduk, 16677 Suwon-si, Gyeonggi-do (KR)
(74) Representative: Kuhnen & Wacker Patent- und Rechtsanwaltsbüro PartG mbB

(57) **Abstract**

An example storage device includes a nonvolatile memory device, and a storage controller that transmits a command and address to the nonvolatile memory device through first lines and communicates data with the nonvolatile memory device through second lines. The storage controller sets security erase operation parameters associated with a security erase operation of the nonvolatile memory device by transmitting setting information through the first lines. The storage controller transmits a security erase command to the nonvolatile memory device through the first lines in response to a security erase request received from an external host device. The nonvolatile memory device performs the security erase operation based on the security erase operation parameters in response to that the security erase command is received from the storage controller. The security erase operation includes an operation of physically erasing first data identified by the security erase command.

## Description

### CROSS-REFERENCE TO RELATED APPLICATION

### BACKGROUND

A storage device stores data under control of a host device, such as a computer, a smartphone, or a smart pad. The storage device stores data on a magnetic disk, such as a hard disk drive (HDD), or stores data in a semiconductor memory, in particular, a nonvolatile memory, such as a solid state drive (SSD) or a memory card.

The nonvolatile memory includes a read only memory (ROM), a programmable ROM (PROM), an electrically programmable ROM (EPROM), an electrically erasable and programmable ROM (EEPROM), a flash memory, a phase-change RAM (PRAM), a magnetic RAM (MRAM), a resistive RAM (RRAM), a ferroelectric RAM (FRAM), etc.

The operating speed of the host device, which communicates with the storage device, such as a computer, a smartphone, or a smart pad, has been improved as semiconductor manufacturing technologies develop. Also, the size of content used in the storage device and the host device of the storage device has been increasing. Therefore, the operating speed of the storage device is desired to be improved.

### SUMMARY

The present disclosure relates to a storage device performing a security erase operation at an improved speed and an operating method of the storage device.

In some implementations, a storage device includes a nonvolatile memory device, and a storage controller that transmits a command and address to the nonvolatile memory device through first lines and communicates data with the nonvolatile memory device through second lines. The storage controller sets security erase operation parameters associated with a security erase operation of the nonvolatile memory device by transmitting setting information through the first lines. The storage controller transmits a security erase command to the nonvolatile memory device through the first lines in response to a security erase request received from an external host device. The nonvolatile memory device performs the security erase operation based on the security erase operation parameters in response to that the security erase command is received from the storage controller. The security erase operation includes an operation of physically erasing first data identified by the security erase command.

In some implementations, a storage device includes a nonvolatile memory device, and a storage controller that transmits a command and address to the nonvolatile memory device through first lines and communicates data with the nonvolatile memory device through second lines. The storage controller transmits a security erase command to the nonvolatile memory device through the first lines in response to a security erase request received from an external host device. The nonvolatile memory device performs a security erase operation in response to that the security erase command is received from the storage controller. The security erase operation includes an operation of physically erasing first data identified by the security erase command. After starting the security erase operation, the storage controller receives a new command from the external host device through the first lines. In response to a suspend request received from the external host device through the first lines, the storage controller suspends the security erase operation. In response to a resume request received from the external host device through the first lines, the storage controller resumes the security erase operation.

In some implementations, an operating method of a storage device which includes a nonvolatile memory device, and a storage controller transmitting a command and address to the nonvolatile memory device through first lines and communicating data with the nonvolatile memory device through second lines includes setting, at the storage device, security erase operation parameters associated with a security erase operation of the nonvolatile memory device through the first lines, transmitting, at the storage controller, a security erase command to the nonvolatile memory device through the first lines in response to a security erase request received from an external host device, and performing, at the nonvolatile memory device, the security erase operation based on the security erase operation parameters in response to that the security erase command is received from the storage controller. The security erase operation includes an operation of physically erasing first data identified by the security erase command.

### BRIEF DESCRIPTION OF THE DRAWINGS

The above and other objects and features of the present disclosure will become apparent by describing in some implementations thereof with reference to the accompanying drawings.
FIG. 1 illustrates an example of a computing device.
FIG. 2 illustrates a first example of operations which a computing device performs.
FIG. 3 illustrates a second example of operations which a computing device performs.
FIG. 4 illustrates an example in which a storage controller manages a mapping table.
FIG. 5 illustrates an example in which an erase operation is performed in a nonvolatile memory device.
FIG. 6 illustrates an example in which a security erase operation is performed in a nonvolatile memory device.
FIG. 7A illustrates an example of a security erase request which a host transmits to a storage controller.
FIG. 7B illustrates an example of a security erase command which a storage controller transmits to a nonvolatile memory device.
FIG. 8 illustrates an example in which a mapping table is managed in relation to an erase operation.
FIG. 9 illustrates an example in which a mapping table is managed in relation to a security erase operation.
FIG. 10 is a block diagram illustrating an example of a nonvolatile memory device.
FIG. 11 is a circuit diagram illustrating an example of one memory block among memory blocks of FIG. 10.
FIG. 12 illustrates a side view of an example of an a-th memory block.
FIG. 13 illustrates an example of an a-th memory block in which super sub-blocks are differently allocated.
FIG. 14A illustrates an example of a security erase request which a host transmits to a storage controller.
FIG. 14B illustrates an example of a security erase command which a storage controller transmits to a nonvolatile memory device.
FIG. 15 illustrates an example of a method in which a computing device suspends and resumes a security erase operation.
FIG. 16 illustrates an example of a process in which a computing device suspends and resumes a security erase operation depending on the method of FIG. 15.
FIG. 17 is a diagram illustrating an example of a system.

### DETAILED DESCRIPTION

Below, implementations of the present disclosure will be described in detail and clearly to such an extent that an ordinary one in the art easily carries out the present disclosure.

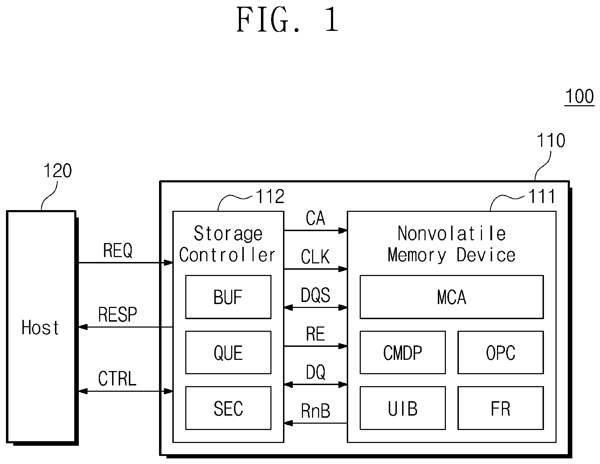

FIG. 1 illustrates an example of a computing device 100. Referring to FIG. 1, the computing device 100 may include a storage device 110 and a host (or a host device) 120.

The storage device 110 may operate under control of the host 120. The storage device 110 may include a nonvolatile memory device 111 and a storage controller 112.

The storage controller 112 may transmit a command and address CA to the nonvolatile memory device 111. For example, the storage controller 112 may transmit a clock signal CLK to the nonvolatile memory device 111 and may transmit the command and address CA to the nonvolatile memory device 111 in synchronization with the clock signal CLK.

The storage controller 112 may communicate a data strobe signal DQS with the nonvolatile memory device 111 and may transmit a read enable signal RE to the nonvolatile memory device 111. The storage controller 112 may communicate data DQ with the nonvolatile memory device 111 in synchronization with the data strobe signal DQS.

In some implementations, when the storage controller 112 transmits the data DQ to the nonvolatile memory device 111, the storage controller 112 may transmit the data strobe signal DQS to the nonvolatile memory device 111 and may transmit the data DQ to the nonvolatile memory device 111 in synchronization with the data strobe signal DQS.

When the storage controller 112 receives the data DQ from the nonvolatile memory device 111, the storage controller 112 may transmit the read enable signal RE to the nonvolatile memory device 111. The nonvolatile memory device 111 may delay the read enable signal RE to generate the data strobe signal DQS. The nonvolatile memory device 111 may transmit the data strobe signal DQS to the storage controller 112 and may transmit the data DQ to the storage controller 112 in synchronization with the data strobe signal DQS.

The nonvolatile memory device 111 may transmit a ready/busy signal RnB to the storage controller 112. When the ready/busy signal RnB is at a first level (e.g., a high level), the ready/busy signal RnB may indicate that the nonvolatile memory device 111 is in a state where it is possible to receive a new command and to perform a new access operation to data written in the nonvolatile memory device 111. When the ready/busy signal RnB is at a second level (e.g., a row level), the ready/busy signal RnB may indicate that the nonvolatile memory device 111 is in a state where it is impossible to receive a new command and to perform a new access operation to data written in the nonvolatile memory device 111.

The nonvolatile memory device 111 may include a memory cell array MCA, a command parser CMDP, an operation controller OPC, a universal internal buffer UIB, and a feature register FR.

The memory cell array MCA may include a plurality of memory cells. The nonvolatile memory device 111 may store data in the memory cells of the memory cell array MCA. The data stored in the memory cells of the memory cell array MCA may be retained even though the power of the storage device 110 is turned off.

The command parser CMDP may parse a command received as the command and address CA from the storage controller 112. The command parser CMDP may transfer a result of the parsing to the operation controller OPC. The operation controller OPC may control an operation of the nonvolatile memory device 111, based on the parsing result of the command parser CMDP. For example, the operation controller OPC may control the nonvolatile memory device 111 to perform the read operation, the write operation, or the erase operation.

The universal internal buffer UIB may store settings associated with various operations of the nonvolatile memory device 111. For example, the universal internal buffer UIB may store various parameters associated with the read operation, the write operation, or the erase operation, such as voltage levels and voltage application times. The universal internal buffer UIB may be implemented with an electrical fuse. As the storage controller 112 transmits a specific command through first lines through which the command and address CA is transferred, the storage controller 112 may enter a mode of setting the universal internal buffer UIB and may set values of the universal internal buffer UIB through second lines through which the data DQ are transferred. Afterwards, as the storage controller 112 transmits the specific command or another specific command through the first lines through which the command and address CA is transferred, the storage controller 112 may terminate the mode of setting the universal internal buffer UIB.

The feature register FR may store various features associated with a command received through the first lines through which the command and address CA is transferred. For example, the feature register FR may store information about whether to execute each command in any manner. The storage controller 112 may set the feature register FR by transmitting a set feature command through the first lines through which the command and address CA is transferred.

The storage controller 112 may receive a request REQ from the host 120. In response to the request REQ, the storage controller 112 may transmit the command and address CA to the nonvolatile memory device 111 to perform a specific operation or may perform an internal operation. When the operation according to the request REQ is completed, the storage controller 112 may transmit a response RESP to the host 120. The response RESP may include information about the request REQ and information about an execution result of the operation according to the request REQ. The storage controller 112 may communicate various control signals CTRL for management of the storage device 110 with the host 120.

The storage controller 112 may include a buffer memory BUF, a queue QUE, and a security erase controller SEC. The storage controller 112 may buffer data to be written from the host 120 to the nonvolatile memory device 111 and data to be read from the nonvolatile memory device 111 to the host 120 by using the buffer memory BUF.

The storage controller 112 may read a map table or a portion of the map table from the nonvolatile memory device 111 so as to be stored in the buffer memory BUF. The map table may include information about a relationship between logical addresses managed by the host 120 and physical addresses of the nonvolatile memory device 111. The storage controller 112 may generate the map table when data are written in the nonvolatile memory device 111 by the host 120. The storage controller 112 may process a read request of the host 120 by using the generated map table.

The storage controller 112 may queue requests transferred from the host 120 in the queue QUE. The storage controller 112 may perform ordering of changing an execution order of requests enqueued into the queue QUE.

The security erase controller SEC of the storage controller 112 may control a security erase operation. For example, when a security erase request is received from the host 120, the security erase controller SEC of the storage controller 112 may perform the security erase operation.

For example, the nonvolatile memory device 111 may include a NAND flash memory device. The nonvolatile memory device 111 may not support an overwrite operation. When the host 120 requests the update of data written in the storage device 110, the storage controller 112 may invalidate original data by marking the original data present in the nonvolatile memory device 111 in the map table as "invalid" and may write update data in a free region. Through the invalidation of data, the storage controller 112 may decrease the number of times of occurrence of the read operation, the write operation, and the erase operation in the nonvolatile memory device 111 and may improve the lifetime of the nonvolatile memory device 111.

A portion of data which the host 120 stores in the storage device 110 may be security data requiring high security. For example, the host 120 may store a key for data encryption in the storage device 110. Even though the security data are invalidated in the map table of the storage device 110, the security data may be exposed by a means such as hacking. Accordingly, the host 120 may request physical erase of the security data from the storage device 110 rather than the invalidation of the security data. For example, the host 120 may request physical erase of data associated with the security erase request by transmitting the security erase request to the storage device 110.

In response to the security erase request of the host 120, the storage controller 112 may physically erase data of the nonvolatile memory device 111, which are associated with the security erase request. For example, the security erase controller SEC of the storage controller 112 may control the security erase operation in response to the security erase request. The security erase controller SEC may control the nonvolatile memory device 111 such that data identified by the security erase request are physically erased. In some implementations, when copy data of the security data, for example, invalidated copy data of the security data exist, the storage controller 112 may also physically erase the invalidated copy data.

In some implementations, the host 120 may activate or deactivate the security erase operation according to the security erase request. In some implementations, the host 120 may activate or deactivate the security erase operation through a universal flash storage (UFS) query request UFS protocol information unit (UPIU).

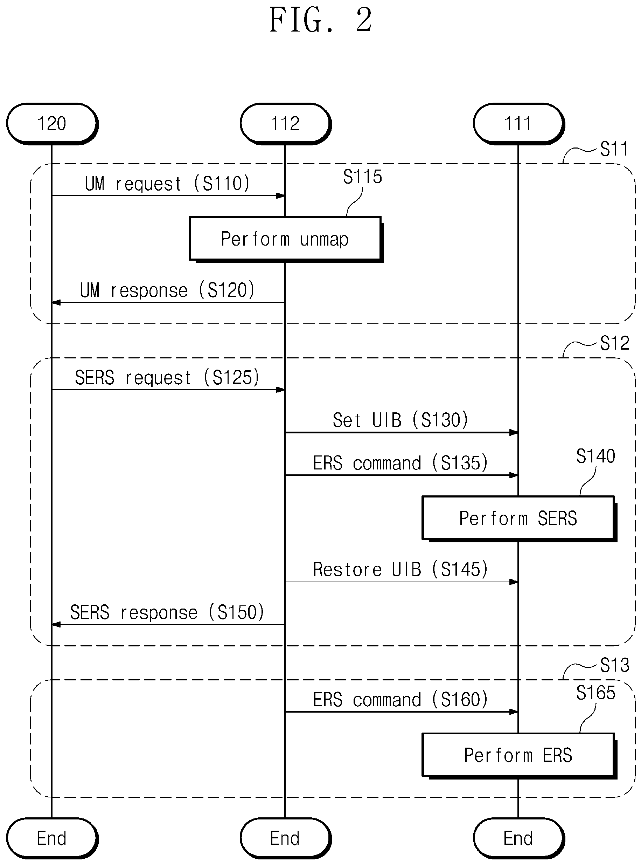

FIG. 2 illustrates a first example of operations which the computing device 100 performs. Referring to FIGS. 1 and 2, in operation S110, the host 120 may transmit a unmap (UM) request to the storage controller 112. The unmap (UM) request may be used to request the storage controller 112 to process the corresponding data so as not to be read from the storage device 110 even though the corresponding data are requested to be read.

In operation S115, the storage controller 112 may perform the unmap (UM) operation. For example, the storage controller 112 may add a flag indicating invalidation to data corresponding to the unmap (UM) request in a mapping table stored in the buffer memory BUF. Afterwards, when the data read-requested from the host 120 correspond to the flag indicating invalidation, the storage controller 112 may not output the data, may output dummy data, or may output an error message.

In operation S120, the storage controller 112 may transmit a unmap (UM) response to the host 120. The unmap (UM) response may include information about the unmap (UM) request in operation S110 and information (e.g., success or failure) about a unmap (UM) result.

In some implementations, operation S110, operation S115, and operation S120 may be included in operation S11 being atomical. Operation S11 may be an operation in which the host 120 requests the storage device 110 to erase data.

In operation S125, the host 120 may transmit the security erase request to the storage controller 112.

In operation S130, the security erase controller SEC of the storage controller 112 may set the universal internal buffer UIB of the nonvolatile memory device 111 in response to the security erase request. For example, the storage controller 112 may change voltage parameters associated with the erase operation of the nonvolatile memory device 111, for example, a voltage level (e.g., an initial erase voltage and a verify voltage), a voltage increment, or a voltage application time.

In operation S135, the storage controller 112 may transmit an erase (ERS) command to the nonvolatile memory device 111. For example, the storage controller 112 may transmit the erase (ERS) command for memory cells in which invalid data are stored.

In operation S140, the nonvolatile memory device 111 may perform the security erase (SERS) operation based on the settings of the universal internal buffer UIB. In operation S145, the storage controller 112 may restore the settings of the universal internal buffer UIB of the nonvolatile memory device 111.

In some implementations, a process in which the storage controller 112 changes the settings of the universal internal buffer UIB in relation to the erase operation, transmits the erase (ERS) command, and restores the settings of the universal internal buffer UIB is described. In addition, the storage controller 112 may further perform an operation of changing the settings of the universal internal buffer UIB in relation to the program operation, may transmit a program command, and may restore the settings of the universal internal buffer UIB.

When the nonvolatile memory device 111 performs the erase operation or the program operation in response to the security erase request, data associated with the security erase request may be in a physically read-impossible state. In operation S150, the storage controller 112 may transmit a security erase response to the host 120. The security erase response may include information about the security erase request in operation S125 and information (e.g., success or failure) about a result of a security erase operation.

In some implementations, operation S125, operation S130, operation S135, operation S140, operation S145, and operation S150 may be included in operation S12 being atomical. Operation S12 may be an operation in which the host 120 requests the storage device 110 to physically erase data. For example, operation S12 may be an operation in which the security erase operation is performed.

In operation S160, the storage controller 112 may transmit the erase (ERS) command to the nonvolatile memory device 111. For example, as a portion of a background operation such as a garbage collection operation or a free block secure operation, the storage controller 112 may transmit the erase (ERS) command to the nonvolatile memory device 111. The storage controller 112 may transmit the erase (ERS) command for memory cells in which invalid data are stored.

In operation S165, the nonvolatile memory device 111 may perform the erase (ERS) operation in response to the erase (ERS) command. Because the erase (ERS) operation performed as the background operation is not caused by the host 120, the storage controller 112 may not transmit a separate response to the host 120.

In some implementations, operation S160 and operation S165 may be included in operation S13 being atomical. Operation S13 may be an operation in which the storage device 110 secures a free block as the background operation.

As described above, an operation of performing the security erase operation according to the first example, that is, operation S12 may include operations of changing and restoring the settings of the universal internal buffer UIB. The number of latches (e.g., electrical fuses) of the universal internal buffer UIB to be changed for the security erase operation may be multiple. When at least one of the settings of the universal internal buffer UIB is abnormally changed, the nonvolatile memory device 111 may abnormally operate. That is, an error may occur in the storage device 110.

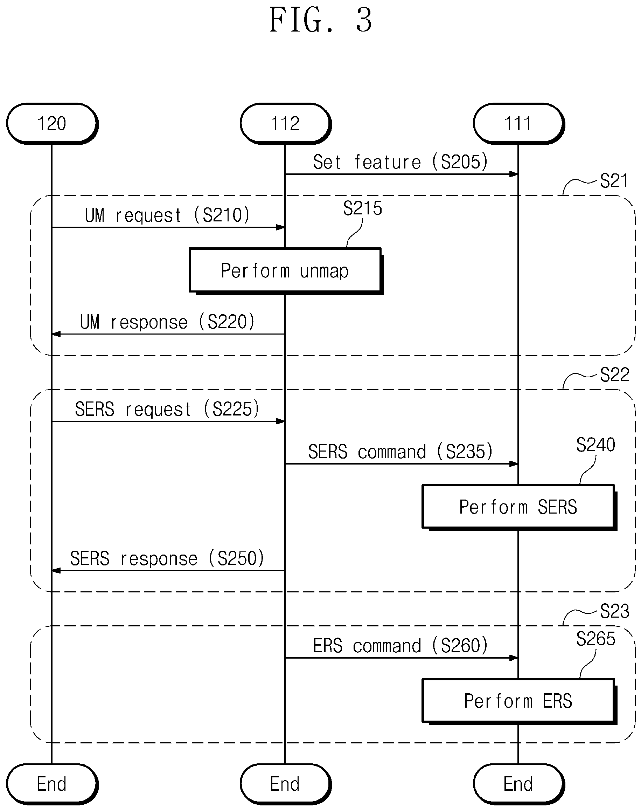

FIG. 3 illustrates a second example of operations which the computing device 100 performs. Referring to FIGS. 1 and 3, in operation S205, the storage controller 112 may set the feature register FR of the nonvolatile memory device 111 by using a set feature command. For example, the storage controller 112 may set registers associated with the security erase (SERS) command. For example, the set feature command may include a voltage level (e.g., an initial erase voltage and a verify voltage), a voltage increment, or a voltage application time of the erase operation associated with the security erase (SERS) command. The set feature command may include a voltage level (e.g., an initial program voltage and a verify voltage), a voltage increment, or a voltage application time of a pre-program operation associated with the security erase (SERS) command.

In operation S210, the host 120 may transmit the unmap (UM) request to the storage controller 112. The unmap (UM) request may be used to request the storage controller 112 to process the corresponding data so as not to be read from the storage device 110 even though the corresponding data are requested to be read.

In operation S215, the storage controller 112 may perform unmap (UM). For example, the storage controller 112 may add a flag indicating invalidation to data corresponding to the unmap (UM) request in the mapping table stored in the buffer memory BUF. Afterwards, when the data read-requested from the host 120 correspond to the flag indicating invalidation, the storage controller 112 may not output the data, may output dummy data, or may output an error message.

In operation S220, the storage controller 112 may transmit the unmap (UM) response to the host 120. The unmap (UM) response may include information about the unmap (UM) request in operation S210 and information (e.g., success or failure) about a unmap (UM) result.

In some implementations, operation S210, operation S215, and operation S220 may be included in operation S21 being atomical. Operation S21 may be an operation in which the host 120 requests the storage device 110 to erase data.

In operation S225, the host 120 may transmit the security erase request to the storage controller 112.

In operation S235, the storage controller 112 may transmit the security erase (SERS) command to the nonvolatile memory device 111 in response to the security erase request. For example, the storage controller 112 may transmit the security erase (SERS) command for memory cells in which invalid data are stored.

In operation S240, the nonvolatile memory device 111 may perform the security erase (SERS) operation based on features of the security erase (SERS) command stored in the feature register FR. For example, the security erase (SERS) operation may include the erase operation, the pre-program operation, or the erase operation and the pre-program operation.

When the nonvolatile memory device 111 performs the security erase (SERS) operation in response to the security erase request, data associated with the security erase request may be in a physically read-impossible state. In operation S250, the storage controller 112 may transmit a security erase response to the host 120. The security erase response may include information about the security erase request in operation S225 and information (e.g., success or failure) about a result of the security erase operation.

In some implementations, operation S225, operation S235, operation S240, and operation S250 may be included in operation S22 being atomical. Operation S22 may be an operation in which the host 120 requests the storage device 110 to physically erase data. For example, operation S22 may be an operation in which the security erase operation is performed.

In operation S260, the storage controller 112 may transmit the erase (ERS) command to the nonvolatile memory device 111. For example, as a portion of a background operation such as a garbage collection operation or a free block secure operation, the storage controller 112 may transmit the erase (ERS) command to the nonvolatile memory device 111. The storage controller 112 may transmit the erase (ERS) command for memory cells in which invalid data are stored.

In operation S265, the nonvolatile memory device 111 may perform the erase (ERS) operation in response to the erase (ERS) command. Because the erase (ERS) operation performed as the background operation is not caused by the host 120, the storage controller 112 may not transmit a separate response to the host 120.

In some implementations, operation S260 and operation S265 may be included in operation S23 being atomical. Operation S23 may be an operation in which the storage device 110 secures a free block as the background operation.

As described above, an operation of performing the security erase operation according to the second example, that is, operation S22 may include an operation of performing the security erase operation without changing the settings of the universal internal buffer UIB. Accordingly, an error may be prevented from occurring in the universal internal buffer UIB while the security erase operation is performed.

Also, the set feature command and the security erase (SERS) command in operation S22 where the security erase operation according to the second example is performed are provided through only the first lines transferring the command and address CA. Accordingly, even while the storage controller 112 communicates the data DQ with the nonvolatile memory device 111 in response to a previous command transferred from the host 120 to the storage controller 112, the storage controller 112 may transmit the set feature command the security erase (SERS) command to the nonvolatile memory device 111 in parallel. Accordingly, a speed of the security erase operation may be improved.

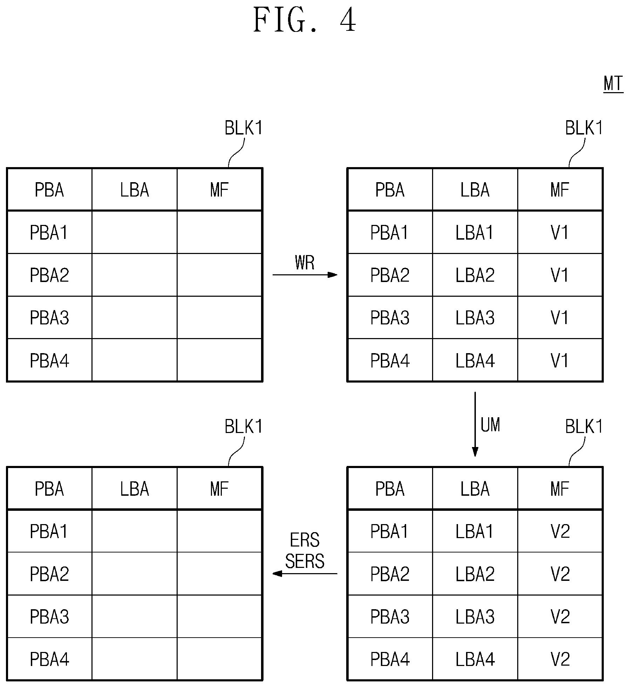

FIG. 4 illustrates an example in which the storage controller 112 manages a mapping table MT. Referring to FIGS. 1, 3, and 4, the memory cell array MCA may include a plurality of memory blocks. Each of the plurality of memory blocks may include a plurality of memory cells. The storage controller 112 may manage a first physical address PBA1, a second physical address PBA2, a third physical address PBA3, and a fourth physical address PBA4 in a field of physical addresses of the first memory block BLK1 of the nonvolatile memory device 111.

In a state where data are not stored in the first memory block BLK1, a logical address LBA and a mapping flag MF corresponding to the physical address PBA may have an initial value.

When data are written in the first memory block BLK1 of the nonvolatile memory device 111 through the write (WR) operation, logical addresses of the data, for example, a first logical address LBA1, a second logical address LBA2, a third logical address LBA3, and a fourth logical address LBA4 may be respectively written in the field of the logical address LBA in relation to the first physical address PBA1, the second physical address PBA2, the third physical address PBA3, and the fourth physical address PBA4 of the physical address PBA of the mapping table MT which the storage controller 112 manages. The storage controller 112 may record first values V1, which indicate that a mapping relationship is valid, at fields of the mapping flag MF in relation to the first physical address PBA1, the second physical address PBA2, the third physical address PBA3, and the fourth physical address PBA4 of the physical address PBA of the mapping table MT.

When the unmap (UM) operation is performed in response to the unmap (UM) request of the host 120, the data written in the first memory block BLK1 may be invalidated. The storage controller 112 may update the mapping flag MF of the mapping table MT of the first memory block BLK1 so as to be changed to second values V2 indicating that a mapping relationship is invalid.

The storage controller 112 may erase memory cells of the first memory block BLK1 through the security erase (SERS) operation or the erase (ERS) operation. When the first memory block BLK1 is erased, the storage controller 112 may delete the fields of the logical address LBA of the first memory block BLK1 and the fields of the mapping flag MF of the first memory block BLK1.

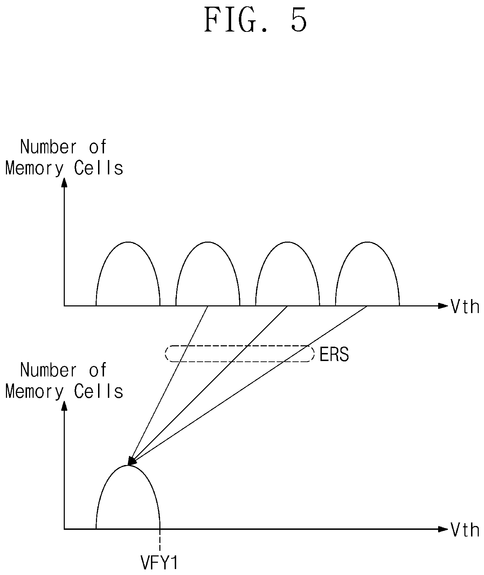

FIG. 5 illustrates an example in which an erase (ERS) operation is performed in the nonvolatile memory device 111. In FIG. 5, the horizontal axis represents a threshold voltage VTH of a memory cell, and the vertical axis represents the number of memory cells.

Referring to FIGS. 1, 3, 4, and 5, when data are written through the write (WR) operation, memory cells of the first memory block BLK1 may be programmed to be included in different threshold voltage ranges. Different threshold voltage ranges may correspond to different states. A state corresponding to the lowest threshold voltage range may be an erase state. Threshold voltage ranges higher than the erase state may respectively correspond to different program states.

When the erase (ERS) operation is performed, the memory cells of the first memory block BLK1 may be erased to the erase state having the threshold voltage range lower than a first verify voltage VFY1.

In some implementations, the erase (ERS) operation may be performed to secure a free block and to write new data in the free block. Because data will be written through the write (WR) operation after the erase (ERS) operation, errors which are capable of occurring when the memory cells are left alone in the erase state may not occur. For example, the deep erase that threshold voltages of the memory cells of the erase state become excessively low may not occur, and there may be no influence on the reliability of data written in the memory cells.

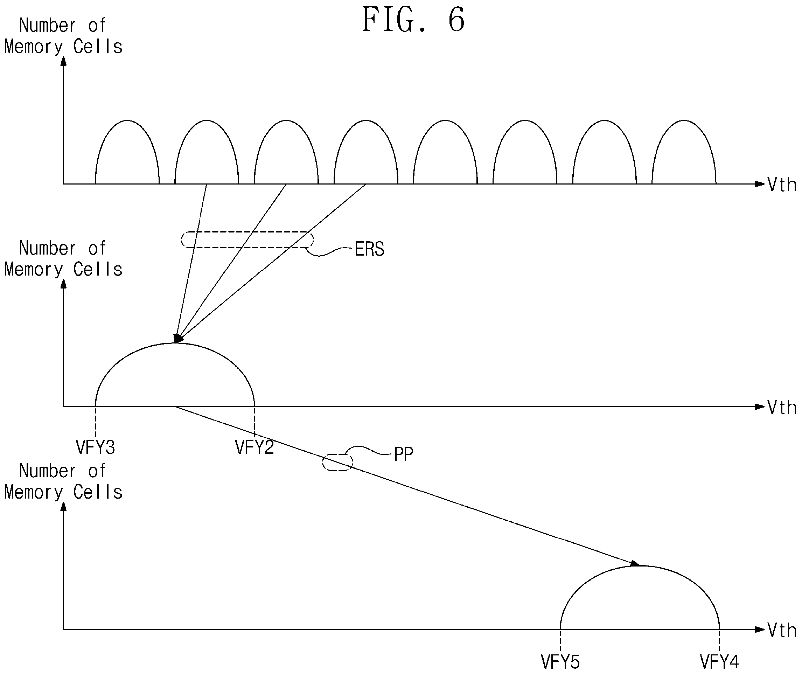

FIG. 6 illustrates an example in which the security erase (SERS) operation is performed in the nonvolatile memory device 111. In FIG. 6, the horizontal axis represents a threshold voltage VTH of a memory cell, and the vertical axis represents the number of memory cells.

Referring to FIGS. 1, 3, 4, and 6, when data are written through the write (WR) operation, memory cells of the first memory block BLK1 may be programmed to be included in different threshold voltage ranges. Different threshold voltage ranges may correspond to different states. A state corresponding to the lowest threshold voltage range may be an erase state. Threshold voltage ranges higher than the erase state may respectively correspond to different program states.

The security erase (SERS) operation may include the erase (ERS) operation and a pre-program (PP) operation. In some implementations, the erase (ERS) operation of the security erase (SERS) operation may be called shallow erase in that the erase is made to be relatively small. When the erase (ERS) operation is performed, the memory cells of the first memory block BLK1 may be erased to a state whose threshold voltage range is lower than a second verify voltage VFY2 and is higher than a third verify voltage VFY3. In some implementations, the level of the second verify voltage VFY2 used in the erase (ERS) operation of the security erase (SERS) operation may be higher than the level of the first verify voltage VFY1 used in the erase (ERS) operation.

When the pre-program (PP) operation is performed, the memory cells of the first memory block BLK1 may be programmed to a state whose threshold voltage range is lower than a fourth verify voltage VFY4 and is higher than a fifth verify voltage VFY5. In some implementations, the level of the fifth verify voltage VFY5 used in the pre-program (PP) operation of the security erase (SERS) operation may be higher than the level of the second verify voltage VFY2 used in the erase (ERS) operation of the security erase (SERS) operation.

In some implementations, a threshold voltage distribution range of memory cells in which the security erase (ERS) operation is performed may be wider than a threshold voltage distribution range of an erase state or one program state when data are written.

In some implementations, the security erase (SERS) operation may be arbitrarily initiated for the host 120 to erase the security data, rather than securing a free block and writing new data. Accordingly, memory cells may be left alone, and error capable of occurring when the memory cells are left alone may occur. For example, the deep erase that threshold voltages of memory cells become lower may occur. The security erase (SERS) operation may be performed to adjust a threshold voltage range of memory cells to be higher than a threshold voltage range of the erase state. In this case, even though threshold voltages of the memory cells become lower, the threshold voltages of the memory cells may not become lower than the threshold voltage range of the erase state.

When the storage controller 112 intends to write data in memory cells of the first memory block BLK1 in which the security erase (SERS) operation is completed, the storage controller 112 may perform the erase (ERS) operation on the memory cells of the first memory block BLK1 such that the first memory block BLK1 is changed to a free block and may then write the data in the first memory block BLK1. Accordingly, the disturbance which is caused when memory cells are left alone in the erase state may not affect the reliability of data to be written later.

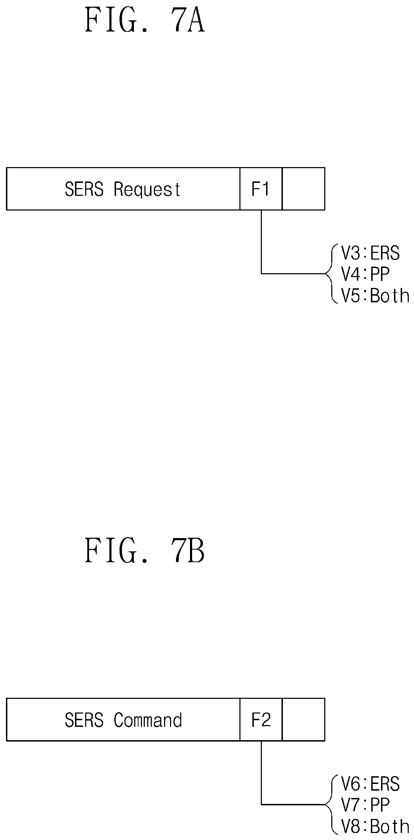

FIG. 7A illustrates an example of the security erase request which the host 120 transmits to the storage controller 112. Referring to FIG. 7A, the security erase request may include a first flag (or a first field) F1.

The first flag F1 may include one of a third value V3, a fourth value V4, and a fifth value V5. The third value V3 may indicate that only the erase (ERS) operation using the second verify voltage VFY2 is performed in the security erase (SERS) operation. The fourth value V4 may indicate that only the pre-program (PP) operation using the fifth verify voltage VFY5 is performed in the security erase (SERS) operation. The fifth value V5 may indicate that both the erase (ERS) operation using the second verify voltage VFY2 and the pre-program (PP) operation using the fifth verify voltage VFY5 are performed in the security erase (SERS) operation.

In some implementations, the pre-program (PP) operation may be used even in any other situation in addition to the security erase (SERS) operation. For example, to prevent the deep erase from occurring at the memory cells of the nonvolatile memory device 111 after the storage device 110 is manufactured, back patterning may be performed to increase threshold voltages of the memory cells. The option of the fourth value V4 indicating only the execution of the pre-program operation may be used to perform the back patterning. Also, even when the dummy pattern is written in a memory block such that the memory block is closed, there may be used the option of the fourth value V4 indicating only the execution of the pre-program operation.

Likewise, instead of using the option of the fourth value V4 indicating only the execution of the pre-program (PP) operation, the option of the third value V3 indicating only the execution of the erase (ERS) operation may also be used for the back patterning or the dummy close.

In some implementations, the first flag F1 may include an additional value configured to indicate the activation or deactivation of the security erase (SERS) operation.

FIG. 7B illustrates an example of the security erase (SERS) command which the storage controller 112 transmits to the nonvolatile memory device 111. Referring to FIG. 7B, the security erase command may include a second flag (or a second field) F2.

The second flag F2 may include one of a sixth value V6, a seventh value V7, and an eighth value V8. The sixth value V6 may indicate that only the erase (ERS) operation using the second verify voltage VFY2 is performed in the security erase (SERS) operation. The seventh value V7 may indicate that only the pre-program (PP) operation using the fifth verify voltage VFY5 is performed in the security erase (SERS) operation. The eighth value V8 may indicate that both the erase (ERS) operation using the second verify voltage VFY2 and the pre-program (PP) operation using the fifth verify voltage VFY5 are performed in the security erase (SERS) operation.

In some implementations, the pre-program (PP) operation may be used even in any other situation in addition to the security erase (SERS) operation. For example, to prevent the deep erase from occurring at the memory cells of the nonvolatile memory device 111 after the storage device 110 is manufactured, back patterning may be performed to increase threshold voltages of the memory cells. The option of the seventh value V7 indicating only the execution of the pre-program operation may be used to perform the back patterning. Also, even when the dummy pattern is written in a memory block such that the memory block is closed, there may be used the option of the seventh value V7 indicating only the execution of the pre-program operation.

Likewise, instead of using the option of the seventh value V7 indicating only the execution of the pre-program (PP) operation, the option of the sixth value V6 indicating only the execution of the erase (ERS) operation may also be used for the back patterning or the dummy close.

In some implementations, the first flag F1 may include an additional value configured to indicate the activation or deactivation of the security erase (SERS) operation.

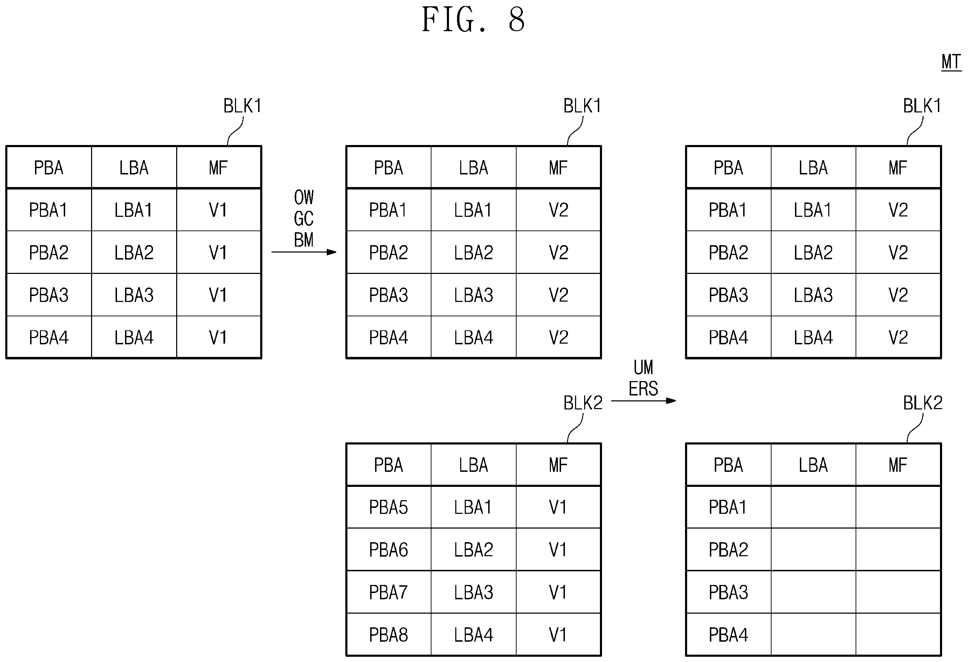

FIG. 8 illustrates an example in which the mapping table MT is managed in relation to the erase (ERS) operation. Referring to FIGS. 1, 4, and 8, when data are written in the first memory block BLK1, the field of the logical address LBA may include logical addresses of data, for example, the first logical address LBA1, the second logical address LBA2, the third logical address LBA3, and the fourth logical address LBA4. The mapping table MT may record the first values V1, which indicate that a mapping relationship is valid, at the fields of the mapping flag MF in relation to the first physical address PBA1, the second physical address PBA2, the third physical address PBA3, and the fourth physical address PBA4 of the physical address PBA of the mapping table MT.

The storage controller 112 may move data of the first memory block BLK1 to the second memory block BLK2 by performing overwrite OW, garbage collection GC, or bad block management BM on the data of the first memory block BLK1.

The storage controller 112 may update the mapping table MT such that the first logical address LBA1, the second logical address LBA2, the third logical address LBA3, and the fourth logical address LBA4 are respectively mapped to a fifth physical address PBA5, a sixth physical address PBA6, a seventh physical address PBA7, and an eighth physical address PBA8 of the second memory block BLK2.

The storage controller 112 may update the mapping flag MF of the mapping table MT of the second memory block BLK2 so as to include the first values V1 indicating valid data. The storage controller 112 may update the mapping flag MF of the mapping table MT of the first memory block BLK1 so as to include the second values V2 indicating invalid data.

After the storage controller 112 updates the mapping flag MF of the second memory block BLK2 in response to the unmap (UM) request of the host 120 so as to be changed to the second values V2 indicating invalid data, the storage controller 112 may perform the erase (ERS) operation as the background operation. Even though the same data are stored in the first memory block BLK1 and the second memory block BLK2, the storage controller 112 may perform the erase (ERS) operation only on one memory block, for example, the data of the second memory block BLK2. That is, copy data of the data stored in the second memory block BLK2 may be present in the first memory block BLK1. The copy data stored in the first memory block BLK1 may be leaked out through the hacking.

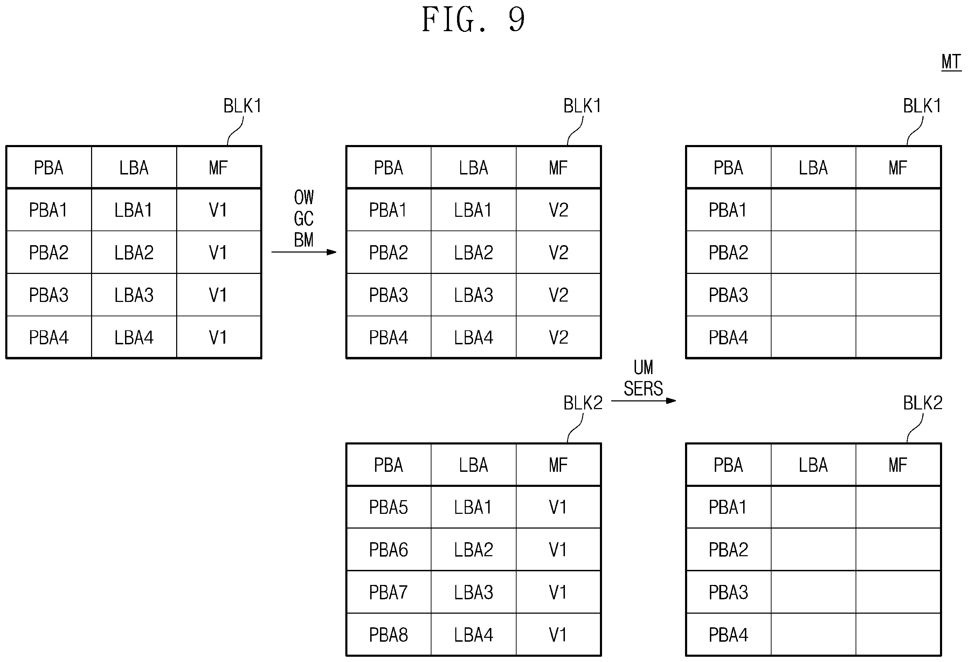

FIG. 9 illustrates an example in which the mapping table MT is managed in relation to the security erase (SERS) operation. Referring to FIGS. 1, 4, and 9, when data are written in the first memory block BLK1, the field of the logical address LBA may include logical addresses of data, for example, the first logical address LBA1, the second logical address LBA2, the third logical address LBA3, and the fourth logical address LBA4. The mapping table MT may record the first values V1, which indicate that a mapping relationship is valid, at the fields of the mapping flag MF in relation to the first physical address PBA1, the second physical address PBA2, the third physical address PBA3, and the fourth physical address PBA4 of the physical address PBA of the mapping table MT.

The storage controller 112 may move data of the first memory block BLK1 to the second memory block BLK2 by performing overwrite OW, garbage collection GC, or bad block management BM on the data of the first memory block BLK1.

The storage controller 112 may update the mapping table MT such that the first logical address LBA1, the second logical address LBA2, the third logical address LBA3, and the fourth logical address LBA4 are respectively mapped to a fifth physical address PBA5, a sixth physical address PBA6, a seventh physical address PBA7, and an eighth physical address PBA8 of the second memory block BLK2.

The storage controller 112 may update the mapping flag MF of the mapping table MT of the second memory block BLK2 so as to include the first values V1 indicating valid data. The storage controller 112 may update the mapping flag MF of the mapping table MT of the first memory block BLK1 so as to include the second values V2 indicating invalid data.

After the storage controller 112 updates the mapping flag MF of the second memory block BLK2 in response to the unmap (UM) request of the host 120 so as to be changed to the second values V2 indicating invalid data, the storage controller 112 may perform the security erase (SERS) operation in response to the security erase request. When data corresponding to the same logical address LBA are present in the first memory block BLK1 and the second memory block BLK2, the storage controller 112 may perform the security erase (SERS) operation on both the data of the first memory block BLK1 and the data of the second memory block BLK2. Accordingly, the probability that data are leaked out may be blocked.

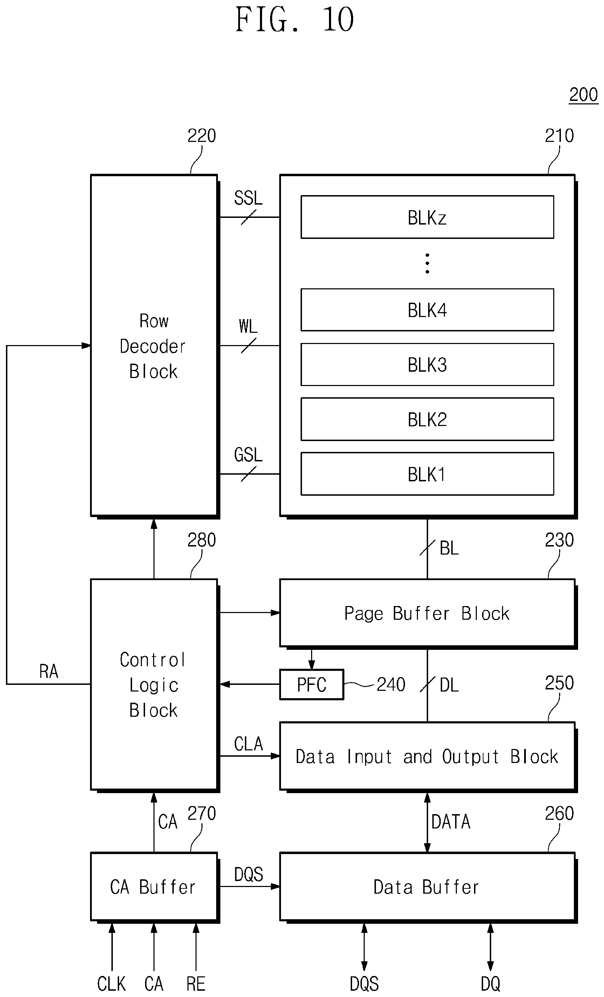

FIG. 10 is a block diagram illustrating an example of a nonvolatile memory device 200. Referring to FIGS. 1 and 10, the nonvolatile memory device 200 includes a memory cell array 210, a row decoder block 220, a page buffer block 230, a pass/fail check block (PFC) 240, a data input and output block 250, a data buffer 260, a command and address buffer 270, and a control logic block 280.

The memory cell array 210 includes a plurality of memory blocks BLK1 to BLKz. Each of the memory blocks BLK1 to BLKz includes a plurality of memory cells. Each of the memory blocks BLK1 to BLKz may be connected to the row decoder block 220 through at least one ground selection line GSL, word lines WL, and at least one string selection line SSL. Some of the word lines WL may be used as dummy word lines. Each of the memory blocks BLK1 to BLKz may be connected to the page buffer block 230 through a plurality of bit lines BL. The plurality of memory blocks BLK1 to BLKz may be connected in common to the plurality of bit lines BL.

In some implementations, each of the plurality of memory blocks BLK1 to BLKz may correspond to a unit of the erase operation. Memory cells belonging to each memory block may be erased at the same time. As another example, each memory block may be divided into a plurality of sub-blocks. Each of the plurality of sub-blocks may correspond to a unit of the erase operation.

The row decoder block 220 is connected to the memory cell array 210 through the ground selection lines GSL, the word lines WL, and the string selection lines SSL. The row decoder block 220 operates under control of the control logic block 280.

The row decoder block 220 may decode a row address RA received from the control logic block 280 and may control voltages to be applied to the string selection lines SSL, the word lines WL, and the ground selection lines GSL based on the decoded row address.

The page buffer block 230 is connected to the memory cell array 210 through the plurality of bit lines BL. The page buffer block 230 is connected to the data input and output block 250 through a plurality of data lines DL. The page buffer block 230 operates under control of the control logic block 280.

In the program operation, the page buffer block 230 may store data to be written in memory cells. The page buffer block 230 may apply voltages to the plurality of bit lines BL based on the stored data. In the read operation or in the verify read operation that is performed in the program operation or the erase operation, the page buffer block 230 may sense voltages of the bit lines BL and may store a sensing result.

In the verify read operation associated with the program operation or the erase operation, the pass/fail check block 240 may verify the sensing result of the page buffer block 230. For example, in the verify read operation which is performed in the program operation, the pass/fail check block 240 may count the number of values (e.g., the number of 0s) corresponding to on-cells which are not programmed to a target threshold voltage or higher.

In the verify read operation which is performed in the erase operation, the pass/fail check block 240 may count the number of values (e.g., the number of 1s) corresponding to off-cells which are not erased to a target threshold voltage or lower. When a counting result is greater than or equal to a threshold value, the pass/fail check block 240 may output a fail signal to the control logic block 280. When the counting result is smaller than the threshold value, the pass/fail check block 240 may output a pass signal to the control logic block 280. Depending on the verification result of the pass/fail check block 240, a program loop of the program operation may be further performed, or an erase loop of the erase operation may be further performed.

The data input and output block 250 is connected to the page buffer block 230 through the plurality of data lines DL. The data input and output block 250 may receive a column address CLA from the control logic block 280. The data input and output block 250 may output data read by the page buffer block 230 to the data buffer 260 depending on the column address CLA. The data input and output block 250 may transfer data received from the data buffer 260 to the page buffer block 230, based on the column address CLA.

The data buffer 260 may operate under control of the control logic block 280. The data buffer 260 may receive the data DQ from the storage controller 112 in synchronization with the data strobe signal DQS from the storage controller 112. The data buffer 260 may receive the data strobe signal DQS from the command and address buffer 270. The data buffer 260 may output the data DQ to the storage controller 112 in synchronization with the data strobe signal DQS received from the command and address buffer 270.

The command and address buffer 270 may operate under control of the control logic block 280. The command and address buffer 270 may receive the command and address CA in synchronization with the clock signal CLK from the storage controller 112. The command and address buffer 270 may transfer the received command and address CA to the control logic block 280. The command and address buffer 270 may receive the read enable signal RE from the storage controller 112. The command and address buffer 270 may delay the read enable signal RE to generate the data strobe signal DQS. The command and address buffer 270 may transfer the generated data strobe signal DQS to the data buffer 260.

The control logic block 280 may receive the command and address CA from the command and address buffer 270. The control logic block 280 may parse a command of the command and address CA received from the command and address buffer 270 and may control the nonvolatile memory device 200 depending on the parsed command. The control logic block 280 may extract the row address RA and the column address CLA by decoding an address of the command and address CA received from the command and address buffer 270. The control logic block 280 may transfer the row address RA to the row decoder block 220 and may transfer the column address CLA to the data input and output block 250.

In some implementations, the control logic block 280 may include the command parser CMDP, the operation controller OPC, the universal internal buffer UIB, and the feature register FR described with reference to FIG. 1.

In some implementations, the nonvolatile memory device 200 may be manufactured in a bonding method. The memory cell array 210 may be manufactured by using a first wafer, and the row decoder block 220, the page buffer block 230, the pass/fail check block 240, the data input and output block 250, the data buffer 260, the command and address buffer 270, and the control logic block 280 may be manufactured by using a second wafer. The non-volatile memory device 200 may be implemented by coupling the first wafer and the second wafer such that an upper surface of the first wafer and an upper surface of the second wafer face each other.

As another example, the nonvolatile memory device 200 may be manufactured in a cell over peri (COP) method. A peripheral circuit including the row decoder block 220, the page buffer block 230, the pass/fail check block 240, the data input and output block 250, the data buffer 260, the command and address buffer 270, and the control logic block 280 may be implemented on a substrate. The memory cell array 210 may be implemented over the peripheral circuit. The peripheral circuit and the memory cell array 210 may be connected by using the through vias.

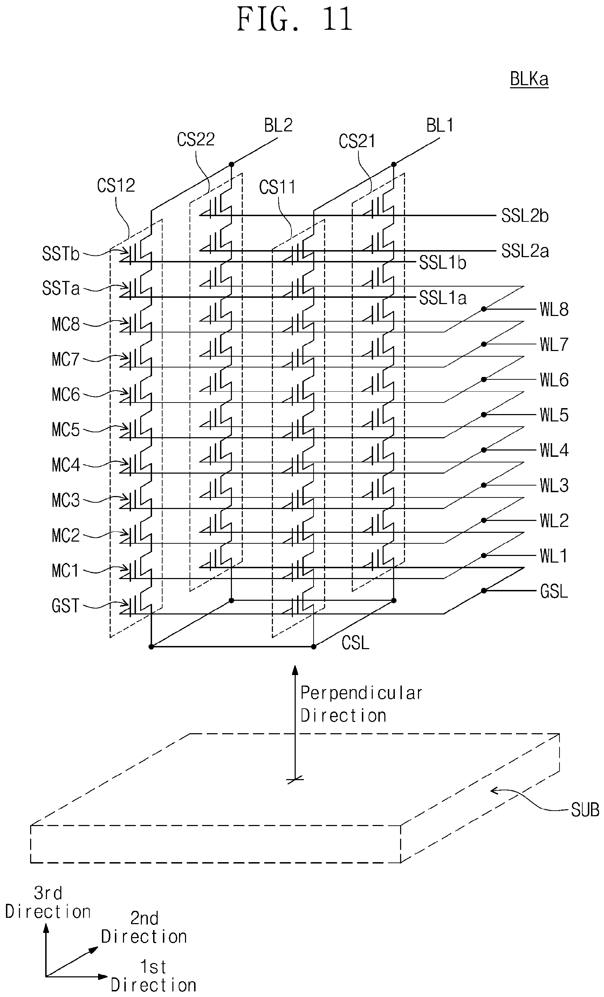

FIG. 11 is a circuit diagram illustrating an example of one memory block BLKa of the memory blocks BLK1 to BLKz of FIG. 10. Referring to FIG. 11, a plurality of cell strings CS11, CS12, CS21, and CS22 may be disposed on a substrate SUB in rows and columns. Each row may extend along a first direction. Each column may extend along a second direction. The plurality of cell strings CS11, CS12, CS21, and CS22 may be connected in common to a common source line CSL formed on (or in) the substrate SUB. In FIG. 3, a location of the substrate SUB is depicted as an example for better understanding of the structure of the memory block BLKa.

Cell strings of each row may be connected in common to the ground selection line GSL and may be connected to corresponding string selection lines among first string selection lines SSL1a and SSL1b and second string selection lines SSL2a and SSL2b. The strings of each column may be connected to a corresponding bit line among a first bit line BL1 and a second bit line BL2.

Each cell string may include at least one ground selection transistor GST connected to the ground selection line GSL and a plurality of memory cells MC1 to MC8 respectively connected to a plurality of word lines WL1 to WL8. Cell strings of the first row may further include string selection transistors SSTa and SSTb respectively connected to the first string selection lines SSL1a and SSL1b. Cell strings of the second row may further include string selection transistors SSTa and SSTb respectively connected to the second string selection lines SSL2a and SSL2b.

In each cell string, the ground selection transistor GST, the memory cells MC1 to MC8, and the string selection transistors SSTa and SSTb may be connected in series in a direction perpendicular to the substrate SUB, for example, a third direction and may be sequentially stacked in the direction perpendicular to the substrate SUB. In each of the cell strings CS11, CS12, CS21, and CS22, at least one of the memory cells MC1 to MC8 may be used as a dummy memory cell. The dummy memory cell may not be programmed (e.g., may be program-inhibited) or may be programmed to be different from that of the remaining memory cells among the memory cells MC1 to MC8.

In some implementations, memory cells that are located at the same height and are associated with one string selection line SSL1a, SSL1b, SSL2a, or SSL2b may constitute one physical page. Memory cells of one physical page may be connected to one sub-word line. Sub-word lines of physical pages located at the same height may be connected in common to one word line. Below, the term "word line" may be used to indicate a word line or a sub-word line and may be interpreted based on the context.

An implementation in which the memory block BLKa includes the cell strings CS11, CS12, CS21, and CS22 at intersections of the first row corresponding to the first string selection lines SSL1a and SSL1b, the second row corresponding to the second string selection lines SSL2a and SSL2b, the first column corresponding to the first bit line BL1, and the second column corresponding to the second bit line BL2 is illustrated, but the numbers of rows and columns of cell strings included in the memory block BLKa are not limited.

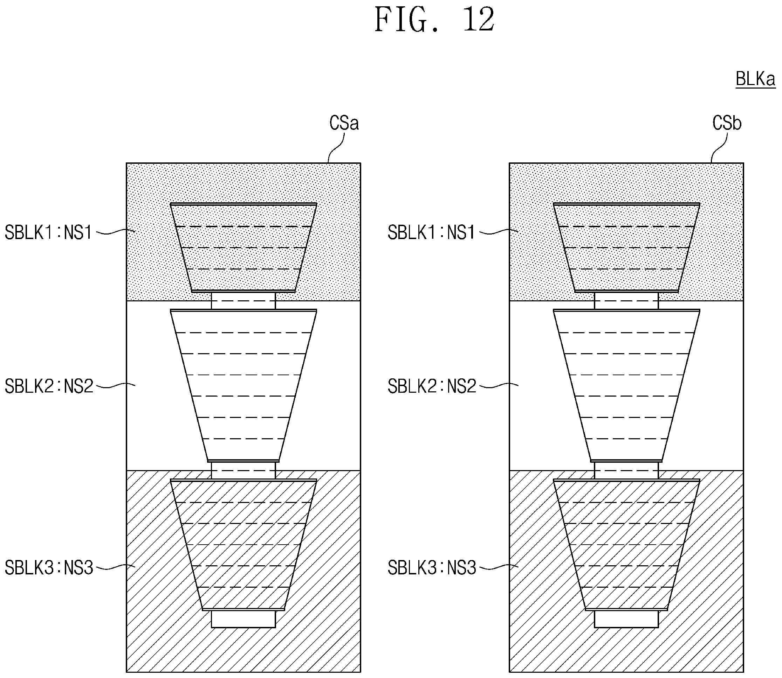

FIG. 12 illustrates a side view of an example of the a-th memory block BLKa. Referring to FIGS. 1, 10, 11, and 12, each of an a-th cell string CSa and a b-th cell string CSb may include a plurality of tiers stacked on a substrate. Each tier may indicate a portion of a cell string, in which a width increases as a distance from the substrate increases. For example, each of the a-th cell string CSa and the b-th cell string CSb may include three tiers.

The storage controller 112 may allocate the tiers of each of the a-th cell string CSa and the b-th cell string CSb to sub-blocks. For example, the storage controller 112 may allocate the tiers of each of the a-th cell string CSa and the b-th cell string CSb to a first sub-block SBLK1, a second sub-block SBLK2, and a third sub-block SBLK3. The sub-block may correspond to a unit of the erase operation. The storage controller 112 may generate the erase (ERS) command for each sub-block.

In some implementations, storage capacities of the tiers included in each of the a-th cell string CSa and the b-th cell string CSb may be different or may be identical. Even in the case where the physical storage capacities of the tiers are different, the storage controller 112 may manage logical storage capacities of the tiers as being identical and may use residual storage capacities as a reserved storage capacity. In each tier, a dotted line may be a division line of memory cells. For example, the tier of the first sub-block SBLK1 may include four layers of memory cells. The tier of the second sub-block SBLK2 may include seven layers of memory cells. The tier of the third sub-block SBLK3 may include six layers of memory cells. However, the number of memory cells included in each tier is not limited thereto. Memory cells belonging to each layer may be connected to the same word line.

The host 120 may allocate namespaces to the storage space of the storage device 110 and may manage data in units of namespace. The storage controller 112 may allocate the sub-blocks of the a-th cell string CSa and the b-th cell string CSb to the namespaces, respectively. For example, the storage controller 112 may tie up the sub-blocks of the a-th cell string CSa and the b-th cell string CSb so as to be allocated to a super sub-block and may allocate the super sub-block to the namespace of the host 120.

For example, the first sub-block SBLK1 at the uppermost end of the a-th cell string CSa and the b-th cell string CSb may be allocated to one super sub-block and may be allocated to a first namespace NS1 of the host 120. The second sub-blocks SBLK2 at the middle of the a-th cell string CSa and the b-th cell string CSb may be allocated to one super sub-block and may be allocated to a second namespace NS2 of the host 120. The third sub-blocks SBLK3 at the lowermost end of the a-th cell string CSa and the b-th cell string CSb may be allocated to one super sub-block and may be allocated to a third namespace NS3 of the host 120.

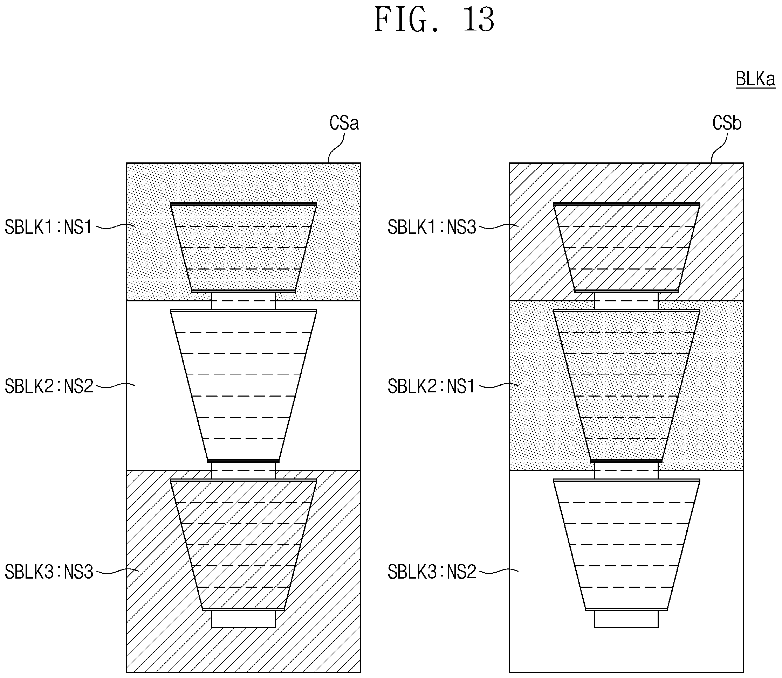

FIG. 13 illustrates an example of the a-th memory block BLKa in which super sub-blocks are differently allocated. Referring to FIGS. 1, 10, 11, and 13, the first sub-block SBLK1 at the uppermost end of the a-th cell string CSa and the second sub-block SBLK2 at the middle of the b-th cell string CSb may be allocated to one super sub-block and may be allocated to the first namespace NS1 of the host 120.

The second sub-block SBLK2 at the middle of the a-th cell string CSa and the third sub-block SBLK3 at the lowermost end of the b-th cell string CSb may be allocated to one super sub-block and may be allocated to the second namespace NS2 of the host 120. The third sub-block SBLK3 at the lowermost end of the a-th cell string CSa and the first sub-block SBLK1 at the uppermost end of the b-th cell string CSb may be allocated to one super sub-block and may be allocated to the third namespace NS3 of the host 120.

As described with reference to FIGS. 12 and 13, the storage controller 112 may allocate sub-blocks of the a-th memory block BLKa to a super sub-block; in this case, the sub-blocks of the a-th memory block BLKa allocated to the super sub-block may be different from the sub-blocks of the b-th cell string CSb allocated to the super sub-block.

The storage controller 112 may allocate the super sub-block to the namespace of the host 120. The host 120 manages data in units of namespace. Accordingly, when the host 120 generates the security erase request, the security erase request may correspond to one namespace. When the storage controller 112 allocate different sub-blocks of the a-th cell string CSa and the b-th cell string CSb to the super sub-block, sub-blocks which are targeted for the security erase (SERS) operation according to the security erase request of the host 120 may be different from each other in the a-th cell string CSa and the b-th cell string CSb.

To support the security erase (SERS) operation on sub-blocks, the storage device 110 may support the security erase (SERS) command for identifying a sub-block.

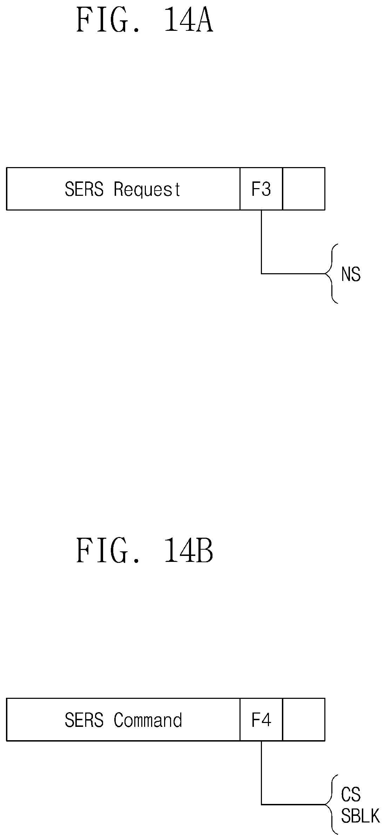

FIG. 14A illustrates an example of the security erase request which the host 120 transmits to the storage controller 112. Referring to FIG. 14A, the security erase request may include a third flag (or a third field) F3. The third flag F3 may include information about a namespace targeted for the security erase (SERS) operation which the host 120 intends to perform through the security erase request.

FIG. 14B illustrates an example of the security erase (SERS) command which the storage controller 112 transmits to the nonvolatile memory device 111. Referring to FIG. 14B, the security erase command may include a fourth flag (or a fourth field) F4.

The fourth flag F4 may include information of cell strings CS on which the security erase (SERS) operation will be performed and the sub-block SBLK of each of the cell strings CS. The storage controller 112 may transmit the security erase (SERS) command to the nonvolatile memory device 111 based on the information of the cell strings CS and the information of the sub-block SBLK of each cell string.

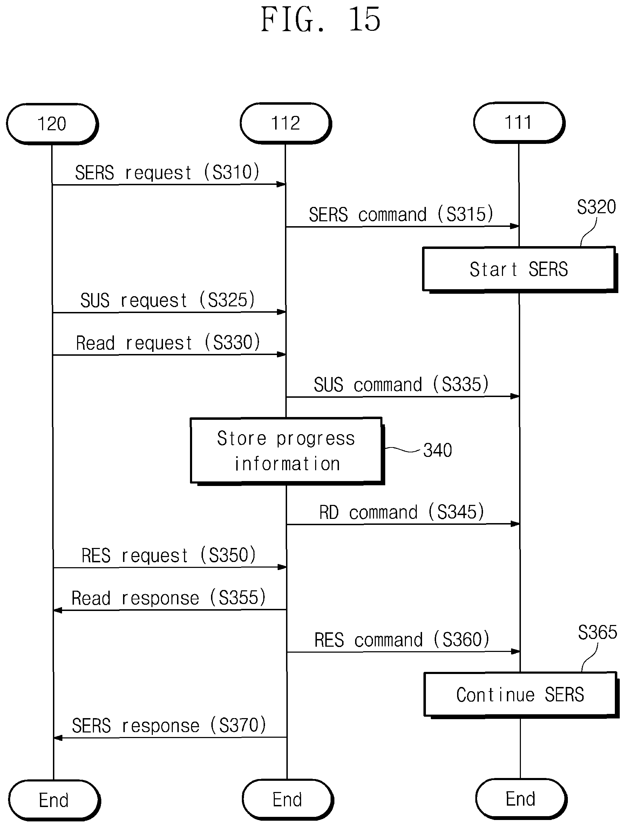

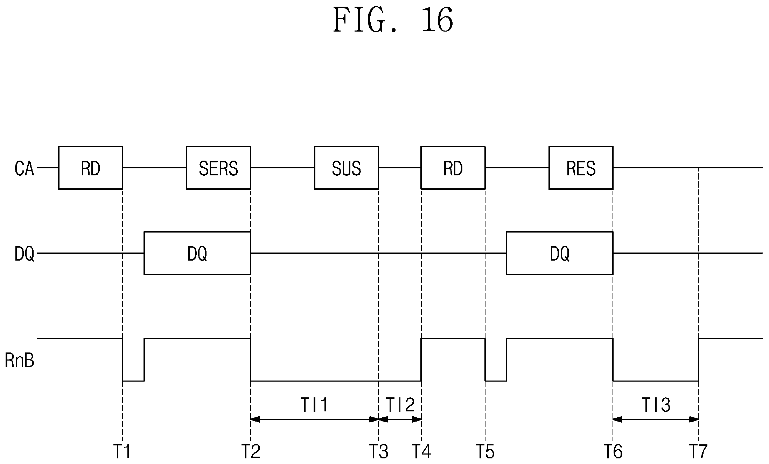

FIG. 15 illustrates an example of a method in which the computing device 100 suspends and resumes the security erase (SERS) operation. FIG. 16 illustrates an example of a process in which the computing device 100 suspends and resumes the security erase (SERS) operation depending on the method of FIG. 15.

Referring to FIGS. 1, 15, and 16, the host 120 may transmit a read (RD) request to the storage controller 112. Before a first timing T1, the storage controller 112 may transmit a read (RD) command to the nonvolatile memory device 111 in response to a previous read (RD) request of the host 120.

At the first timing T1, the storage controller 112 may read data from the nonvolatile memory device 111 in response to the read (RD) command. While the data are read, the nonvolatile memory device 111 may output the ready/busy signal RnB of the low level indicating the busy state to the storage controller 112. After the data are read from the nonvolatile memory device 111, the storage controller 112 may output the data DQ to the host 120 through the second lines.

While the storage controller 112 outputs the data DQ to the host 120 through the second lines, the storage controller 112 may receive a new command and address CA through the first lines. When the security erase (SERS) operation is requested by the host 120, in operation S310, the host 120 may transmit the security erase request to the storage controller 112.

When the output of the data DQ according to the read (RD) command is completed, at a second timing T2, the nonvolatile memory device 111 may change the ready/busy signal RnB to the high level indicating the ready state. When the ready/busy signal RnB transitions to the high level, in operation S315, the storage controller 112 may transmit the security erase (SERS) command to the nonvolatile memory device 111 in response to the security erase request.

When the security erase (SERS) command is received, in operation S320 and at the second timing T2, the nonvolatile memory device 111 may start the security erase (SERS) operation. When the security erase (SERS) operation is started, the nonvolatile memory device 111 may change the ready/busy signal RnB to the low level indicating the busy state.

While the storage device 110 performs the security erase (SERS) operation, the event that data are to be read from the storage device 110 may be generated at the host 120. In operation S325, the host 120 may transmit a suspend (SUS) request to the storage controller 112. For example, the host 120 may request progress information of the security erase (SERS) operation from the storage controller 112. When the security erase (SERS) operation is being performed, the host 120 may transmit the suspend (SUS) request to the storage controller 112.

In operation S330, the host 120 may transmit the read (RD) request corresponding to the generated event to the storage controller 112.

After the security erase (SERS) operation is performed in operation S335 and during a first time interval TI1, at a third timing T3, the storage controller 112 may transmit the suspend (SUS) command to the nonvolatile memory device 111 in response to the suspend (SUS) request and thus may suspend the security erase (SERS) operation being performed on the nonvolatile memory device 111. In operation S340 and during a second time interval TI2, the storage controller 112 may read and store the progress information of the suspended security erase (SERS) operation from the nonvolatile memory device 111.

When the progress information of the security erase (SERS) operation is completely stored, the nonvolatile memory device 111 may change the ready/busy signal RnB to the high level indicating the ready state. In operation S345 and at a fourth timing T4, the storage controller 112 may transmit the read (RD) command to the nonvolatile memory device 111.

At a fifth timing T5, the nonvolatile memory device 111 may read data in response to the read (RD) command. While the data are read, the nonvolatile memory device 111 may change the ready/busy signal RnB to the low level indicating the busy level.

When the read operation is completed, the storage controller 112 may read the data DQ from the nonvolatile memory device 111. While the storage controller 112 reads the data DQ from the nonvolatile memory device 111, the nonvolatile memory device 111 may change the ready/busy signal RnB to the high level indicating the ready state. In operation S350, the host 120 may transmit a resume (RES) request to the storage controller 112.

When the data DQ are completely read, in operation S355, the storage controller 112 may a read response including the data DQ to the host 120.

In operation S350 and at a sixth timing T6 when the output of the data DQ is completed, the storage controller 112 may transmit the resume (RES) command to the nonvolatile memory device 111. In operation S365 and at a third time period TI3, the nonvolatile memory device 111 may resume the security erase (SERS) operation in response to the resume (RES) command. While the security erase (SERS) operation is resumed, the nonvolatile memory device 111 may change the ready/busy signal RnB to the low level indicating the busy level.

When the security erase (SERS) operation is completed, in operation S370 and at a seventh timing T7, the storage controller 112 may transmit the security erase response to the host 120.

As described above, in a separate command address (SCA) structure in which the first lines transferring the command and address CA and the second lines transferring the data DQ are separated from each other, while the nonvolatile memory device 111 performs the security erase (SERS) operation, the storage controller 112 may transmit the suspend (SUS) command and the resume (RES) command to the nonvolatile memory device 111. In particular, the storage controller 112 may transmit the suspend (SUS) command and the resume (RES) command to the nonvolatile memory device 111 while communicating the data DQ with the nonvolatile memory device 111, and the nonvolatile memory device 111 may execute the suspend (SUS) command and the resume (RES) command previously transmitted after the communication of the data DQ is completed. Accordingly, a read latency of the storage device 110 provided to the host 120 may be improved.

An implementation in which the host 120 transmits the suspend (SUS) command, the read (RD) request, and the resume (RES) command to the storage controller 112 is described. However, the host 120 may transmit only the read (RD) request to the storage controller 112. The storage controller 112 may be configured to generate one set including the suspend (SUS) command, the read (RD) request, and the resume (RES) command in response to the read (RD) request.

An implementation in which the storage controller 112 transmits the read response after the host 120 transmits the resume (RES) command is described. However, the host 120 may transmit the resume (RES) command to the storage controller 112 after receiving the read response from the storage controller 112.

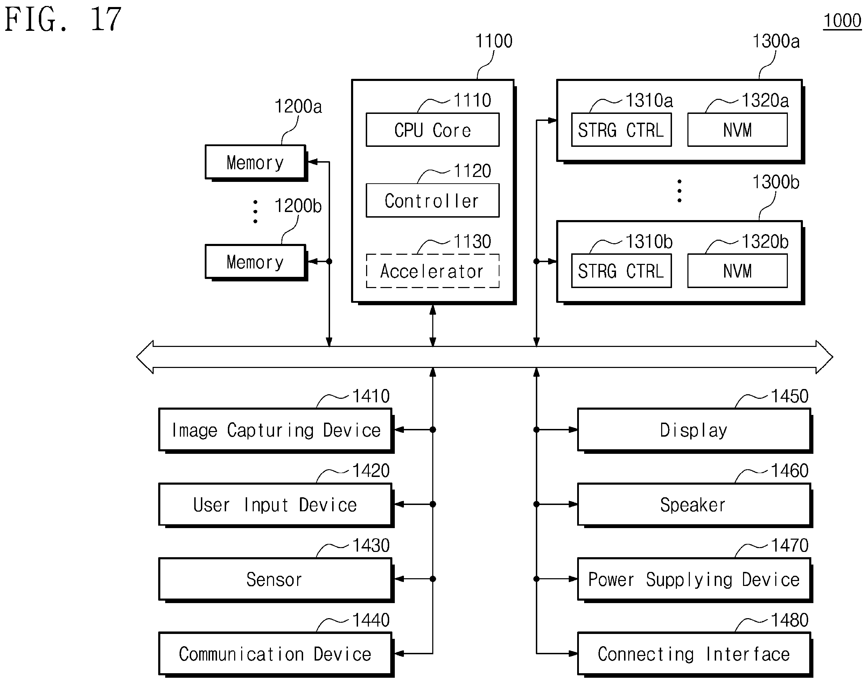

FIG. 17 is a diagram of an example of a system 1000 to which a storage device is applied. The system 1000 of FIG. 17 may basically be a mobile system, such as a portable communication terminal (e.g., a mobile phone), a smartphone, a tablet personal computer (PC), a wearable device, a healthcare device, or an Internet of things (IOT) device. However, the system 1000 of FIG. 17 is not necessarily limited to the mobile system and may be a PC, a laptop computer, a server, a media player, or an automotive device (e.g., a navigation device).

Referring to FIG. 17, the system 1000 may include a main processor 1100, memories (e.g., 1200a and 1200b), and storage devices (e.g., 1300a and 1300b). In addition, the system 1000 may include at least one of an image capturing device 1410, a user input device 1420, a sensor 1430, a communication device 1440, a display 1450, a speaker 1460, a power supplying device 1470, and a connecting interface 1480.

The main processor 1100 may control all operations of the system 1000, more specifically, operations of other components included in the system 1000. The main processor 1100 may be implemented as a general-purpose processor, a dedicated processor, or an application processor.

The main processor 1100 may include at least one CPU core 1110 and further include a controller 1120 configured to control the memories 1200a and 1200b and/or the storage devices 1300a and 1300b. In some implementations, the main processor 1100 may further include an accelerator 1130, which is a dedicated circuit for a high-speed data operation, such as an artificial intelligence (AI) data operation. The accelerator 1130 may include a graphics processing unit (GPU), a neural processing unit (NPU) and/or a data processing unit (DPU) and be implemented as a chip that is physically separate from the other components of the main processor 1100.

The memories 1200a and 1200b may be used as main memory devices of the system 1000. Although each of the memories 1200a and 1200b may include a volatile memory, such as static random access memory (SRAM) and/or dynamic RAM (DRAM), each of the memories 1200a and 1200b may include non-volatile memory, such as a flash memory, phase-change RAM (PRAM) and/or resistive RAM (RRAM). The memories 1200a and 1200b may be implemented in the same package as the main processor 1100.

The storage devices 1300a and 1300b may serve as non-volatile storage devices configured to store data regardless of whether power is supplied thereto, and have larger storage capacity than the memories 1200a and 1200b. The storage devices 1300a and 1300b may respectively include storage controllers (STRG CTRL) 1310a and 1310b and NVM (Non-Volatile Memory)s 1320a and 1320b configured to store data via the control of the storage controllers 1310a and 1310b. Although the NVMs 1320a and 1320b may include flash memories having a two-dimensional (2D) structure or a three-dimensional (3D) V-NAND structure, the NVMs 1320a and 1320b may include other types of NVMs, such as PRAM and/or RRAM.

The storage devices 1300a and 1300b may be physically separated from the main processor 1100 and included in the system 1000 or implemented in the same package as the main processor 1100. In addition, the storage devices 1300a and 1300b may have types of solid-state devices (SSDs) or memory cards and be removably combined with other components of the system 1000 through an interface, such as the connecting interface 1480 that will be described below. The storage devices 1300a and 1300b may be devices to which a standard protocol, such as a universal flash storage (UFS), an embedded multi-media card (eMMC), or a non-volatile memory express (NVMe), is applied, without being limited thereto.

The image capturing device 1410 may capture still images or moving images. The image capturing device 1410 may include a camera, a camcorder, and/or a webcam.

The user input device 1420 may receive various types of data input by a user of the system 1000 and include a touch pad, a keypad, a keyboard, a mouse, and/or a microphone.

The sensor 1430 may detect various types of physical quantities, which may be obtained from the outside of the system 1000, and convert the detected physical quantities into electric signals. The sensor 1430 may include a temperature sensor, a pressure sensor, an illuminance sensor, a position sensor, an acceleration sensor, a biosensor, and/or a gyroscope sensor.

The communication device 1440 may transmit and receive signals between other devices outside the system 1000 according to various communication protocols. The communication device 1440 may include an antenna, a transceiver, and/or a modem.

The display 1450 and the speaker 1460 may serve as output devices configured to respectively output visual information and auditory information to the user of the system 1000.

The power supplying device 1470 may appropriately convert power supplied from a battery embedded in the system 1000 and/or an external power source, and supply the converted power to each of components of the system 1000.

The connecting interface 1480 may provide connection between the system 1000 and an external device, which is connected to the system 1000 and capable of transmitting and receiving data to and from the system 1000. The connecting interface 1480 may be implemented by using various interface schemes, such as advanced technology attachment (ATA), serial ATA (SATA), external SATA (e-SATA), small computer small interface (SCSI), serial attached SCSI (SAS), peripheral component interconnection (PCI), PCI express (PCIe), NVMe, IEEE 1394, a universal serial bus (USB) interface, a secure digital (SD) card interface, a multi-media card (MMC) interface, an eMMC interface, a UFS interface, an embedded UFS (eUFS) interface, and a compact flash (CF) card interface.

In some implementations, the host 120 described with reference to FIGS. 1 to 16 may be implemented with the main processor 1100. In some implementations, the storage device 110 described with reference to FIGS. 1 to 16 may be implemented with one of the storage devices 1300a and 1300b. At least one of the storage devices 1300a and 1300b may be implemented in the SCA structure, may set features associated with the security erase (SERS) operation by using the set feature command, and may be implemented to initiate the security erase (SERS) operation by using the security erase (SERS) command. Also, at least one of the storage devices 1300a and 1300b may support the suspend (SUS) and resume (RES) functions while performing the security erase (SERS) operation.

In the above implementations, components according to the present disclosure are described by using the terms "first", "second", "third", etc. However, the terms "first", "second", "third", etc. may be used to distinguish components from each other and do not limit the present disclosure. For example, the terms "first", "second", "third", etc. do not involve an order or a numerical meaning of any form.

In the above implementations, components according to implementations of the present disclosure are referenced by using blocks. The blocks may be implemented with various hardware devices, such as an integrated circuit, an application specific IC (ASIC), a field programmable gate array (FPGA), and a complex programmable logic device (CPLD), firmware driven in hardware devices, software such as an application, or a combination of a hardware device and software. Also, the blocks may include circuits implemented with semiconductor elements in an integrated circuit, or circuits enrolled as an intellectual property (IP).

According to implementations of the present disclosure, security erase parameters are set through a set feature, the transfer of a security erase command is performed in parallel with the transfer of data, and it is possible to suspend and resume the security erase operation. Accordingly, a storage device performing a security erase operation at an improved speed and an operating method of the storage device are provided.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While the present disclosure has been described with reference to implementations thereof, it will be apparent to those of ordinary skill in the art that various changes and modifications may be made thereto without departing from the spirit and scope of the present disclosure as set forth in the following claims.

## Claims

1. A storage device (110) comprising:
a nonvolatile memory device (111, 200); and
a storage controller (112) configured to
transmit a command and address to the nonvolatile memory device (111, 200) through a plurality of first lines, and
communicate data with the nonvolatile memory device (111, 200) through a plurality of second lines,
wherein the storage controller (112) is configured to transmit setting information through the plurality of first lines and set a plurality of security erase operation parameters associated with a security erase operation of the nonvolatile memory device (111, 200),
wherein the storage controller (112) is configured to transmit, based on a security erase request received from an external host device (120), a security erase command to the nonvolatile memory device (111, 200) through the plurality of first lines,
wherein the nonvolatile memory device (111, 200) is configured to perform the security erase operation based on the plurality of security erase operation parameters and the security erase command, and
wherein the security erase operation includes an operation of physically erasing first data identified by the security erase command.

2. The storage device of claim 1, wherein the storage controller is configured to, during setting the plurality of security erase operation parameters or during transmitting the security erase command, communicate second data with the nonvolatile memory device through the plurality of second lines.

3. The storage device of claim 2, wherein the storage controller is configured to transmit a command to the nonvolatile memory device before setting the plurality of security erase operation parameters or before transmitting the security erase command, and the second data corresponds to the command.

4. The storage device of claim 1, wherein the storage controller is configured to, based on a unmap request received from the external host device, write a value indicating invalid data in a mapping table, the mapping table being associated with third data identified by the unmap request.

5. The storage device of claim 4, wherein the external host device is configured to transmit the security erase request for the third data invalidated by the unmap request.

6. The storage device of claim 4, wherein the storage controller is configured to, during an erase operation as a background operation, physically erase the third data invalidated by the unmap request.

7. The storage device of claim 6, wherein the storage controller is configured to, during the erase operation, decrease a plurality of threshold voltages of a plurality of first memory cells to a first threshold voltage or a voltage lower than the first threshold voltage, the plurality of first memory cells storing the third data, and
wherein the storage controller is configured to, during the security erase operation:
decrease a plurality of threshold voltages of a plurality of second memory cells to a second threshold voltage or a voltage lower than the second threshold voltage, the plurality of second memory cells storing the third data; and
increase the plurality of threshold voltages of the plurality of second memory cells to the second threshold voltage or a voltage higher than the second threshold voltage.

8. The storage device of claim 1, wherein the storage controller is configured to perform at least one of:
decreasing a plurality of threshold voltages of a plurality of memory cells to a first threshold voltage or a voltage lower than the first threshold voltage, the plurality of memory cells storing the first data; or
increasing the plurality of threshold voltages of the plurality of memory cells to a second threshold voltage or a voltage higher than the second threshold voltage.

9. The storage device of claim 8, wherein the security erase request or the security erase command includes a flag requesting to perform at least one of decreasing the plurality of threshold voltages of the plurality of memory cells or increasing the plurality of threshold voltages of the plurality of memory cells.

10. The storage device of claim 1, wherein the storage controller is configured to, based on the security erase request, include, in the security erase command, information about the first data and a plurality of invalidated copies of the first data.

11. The storage device of claim 1, wherein the nonvolatile memory device includes:
a substrate; and
a plurality of cell strings on the substrate along a first direction and a second direction,
wherein each cell string of the plurality of cell strings includes a plurality of tiers stacked on the substrate along a third direction, and
wherein each tier of the plurality of tiers includes a plurality of memory cells stacked along the third direction.

12. The storage device of claim 11, wherein the plurality of tiers correspond to a plurality of sub-blocks different from each other, and
wherein a first sub-block of a first cell string and a second sub-block of a second cell string form a super sub-block.

13. The storage device of claim 12, wherein the storage controller is configured to allocate the super sub-block to a namespace of the external host device, and
wherein the storage controller is configured to, based on the security erase request received from the external host device, include, in the security erase command, information of a location of the first cell string, a location of the first sub-block on the first cell string, a location of the second cell string, and a location of the second sub-block on the second cell string.

14. The storage device of claim 12, wherein a location of the first sub-block on the first cell string is different from a location of the second sub-block on the second cell string.

15. The storage device of claim 14, wherein a capacity of the first sub-block is different from a capacity of the second sub-block.
